# EUROPÄISCHE PATENTSCHRIFT

(11) **EP 0 852 845 B1**
(45) Veröffentlichungstag und Bekanntmachung des Hinweises auf die Patenterteilung: **03.11.1999**
(21) Anmeldenummer: 96932591.9
(22) Anmeldetag: 24.09.1996
(51) Int. Cl.: H03H 1/00

(54) **EINRICHTUNG ZUM ABSORBIEREN DES ELEKTRISCHEN RAUSCHENS**
DEVICE FOR THE ABSORPTION OF ELECTRICAL NOISE
DISPOSITIF D'ABSORPTION DU BRUIT ELECTRIQUE

(30) Priorität: 29.09.1995 DE 19536155
(43) Veröffentlichungstag der Anmeldung: 15.07.1998
(73) Patentinhaber: WÜRTH ELEKTRONIK GmbH & Co. KG, D-74676 Niedernhall (DE)
(72) Erfinder: KONZ, Oliver, D-74532 Ilshofen (DE)
(74) Vertreter: Patentanwälte Ruff, Beier, Schöndorf und Mütschele
(86) Internationale Anmeldenummer: EP9604159
(87) Internationale Veröffentlichungsnummer: WO9713321

(56) Entgegenhaltungen:
- EP-A- 0 452 992

## Beschreibung

Die Erfindung geht aus von einer Einrichtung zum Absorbieren des elektrischen Rauschens mit Hilfe von Elementen aus einem das Rauschen absorbierendem oder verhinderndem Material, die um ein elektrisches Kabel herum angeordnet sind.

Es ist seit langem bekannt, daß man mit Hilfe von Elementen aus ferromagnetischem Material das elektrische Rauschen auf der Leitung reduzieren kann (US-PS 34 62 715).

Ebenfalls bekannt ist es, solche Elemente aus ferromagnetischem Material geteilt herzustellen, so daß man sie nachträglich an einem Kabel anbringen kann. Damit die Wirkung auch gut ist, müssen sich die beiden Teile berühren.

Dies kann beispielsweise dadurch gemacht werden (EP-A-452 992), daß die beiden Halbelemente in einem Gehäuse untergebracht werden, dessen Böden elastische Vorspannmittel aufweisen, die die beiden magnetischen Elemente aufeinander zu pressen.

Der Erfindung liegt die Aufgabe zugrunde, eine Einrichtung zum Absorbieren des elektrischen Rauschens zu schaffen, die einfach aufgebaut ist und bei der sich das Einlegen der Elemente aus einem das Rauschen absorbierendem oder verhinderndem Material leicht gestaltet.

Zur Lösung dieser Aufgabe schlägt die Erfindung eine Einrichtung mit den im Anspruch 1 aufgeführten Merkmalen vor. Weiterbildungen der Erfindung sind Gegenstand von abhängigen Ansprüchen.

Die Einrichtung kann so an einem elektrischen Kabel, in dem das Rauschen verringert werden soll, angebracht werden, daß die beiden Gehäusehalbschalen mit den darin angeordneten Elementen aus dem das Rauschen verhindernden bzw. absorbierenden Material um das Kabel herum angebracht werden. Dies kann beispielsweise durch ein Zusammenklappen oder Zusammenstecken der beiden Gehäusehalbschalen geschehen.

Wenn die beiden Elemente nachträglich in die vorher hergestellten Gehäusehalbschalen eingesetzt werden, geschieht die Anbringung so, daß zunächst die beiden Elemente aus dem Material in die beiden Gehäusehalbschalen eingesetzt und anschließend durch jeweils einen Steg gesichert werden. Der Steg durchsetzt dabei die sowieso vorhandene halbzylindrische Nut des Elementes aus ferromagnetischem Material. Anschließend können die beiden Gehäusehalbschalen um das elektrische Kabel herum zusammengesetzt werden.

Die Verbindung der beiden Gehäusehalbschalen miteinander kann durch Rasteinrichtungen oder auch in sonstiger Weise erfolgen, beispielsweise durch ein um das Gehäuse außen herum gelegtes Klebeband, einen Draht oder dergleichen.

Insbesondere muß zur Verriegelung des Gehäuses vorgesehen sein, daß an einer Gehäusehalbschale eine Lasche vorgesehen ist, die eine Verzahnung aufweist und mit einer Verzahnung an der anderen Halbschale zusammenwirkt. Aufgrund einer feinen Verzahnung läßt sich das Gehäuse in fein abgestuften Stellungen verriegeln, so daß Toleranzen bei der Herstellung der Elemente aus ferromagnetischem Material ausgeglichen werden können.

Es ist möglich, an beiden Längsseiten oder auch an beiden Stirnseiten derartige Laschen und Verzahnungen anzubringen. Die Laschen können insbesondere so angeordnet sein, daß sie auch eine gegenseitige Ausrichtung der beiden Gehäusehalbschalen bewirken.

Die Verzahnungen werden dabei so gewählt, daß sie sägezahnartig sind, also ein unbeabsichtigtes Lösen verhindern.

Es ist ebenfalls möglich, beide Gehäusehalbschalen durch ein Filmscharnier an ihrer jeweils einen Längsseite miteinander zu verbinden, so daß sie dann aus geöffnetem in geschlossenem Zustand verklappt werden können.

Auch hier ist zur Verriegelung eine Lasche mit einer Verzahnung möglich.

Zur winkelmäßigen Ausrichtung eines der beiden Elemente aus ferromagnetischem Material kann am Boden einer Gehäusehalbschale ein starrer, insbesondere abgerundeter Vorsprung angeformt sein, der sich vorzugsweise über die gesamte Länge des Gehäuses erstreckt. Das Ferritelement liegt dann mit seiner Außenseite auf dem Vorsprung auf und kann um dessen Längsachse in gewissen Grenzen noch verkippen.

Erfindungsgemäß kann in Weiterbildung vorgesehen sein, daß der Steg, der zur Festlegung der Ferritelemente dient, die Form eines Halbzylinders aufweist, so daß in zusammengesetztem Zustand des Gehäuses von den Stegen in beiden Halbschalen ein geschlossener Zylinder gebildet wird, der die Innenseite der halbzylindrischen Nuten der Ferritelemente vollständig abdeckt. Die Längskanten der beiden Halbzylinder der Stege liegen in geschlossenem Zustand aneinander an und halten dadurch die Stege in ihrer Position.

Zur Festlegung der Einrichtung an dem elektrischen Kabel kann erfindungsgemäß vorgesehen sein, daß mindestens einer der die Festlegeinrichtung bildenden Stege einen nach innen gerichteten Vorsprung zum Festlegen des Kabels aufweist. Dieser Vorsprung kann elastisch ausgebildet sein. Es ist ebenfalls möglich, daß beide Stege, insbesondere beide Halbzylinder, einen solchen Vorsprung aufweisen. Dieser ist vorzugsweise etwa mittig angeordnet.

Die Stege können in Weiterbildung der Erfindung seitlich in die Gehäusehalbschalen einschiebbar sein. Es ist aber ebenfalls möglich und wird vorgeschlagen, daß der Steg über ein Filmscharnier mit einer Stirnseite einer Gehäusehalbschale verbunden ist.

Weitere Merkmale, Einzelheiten und Vorzüge ergeben sich aus den Patentansprüchen, deren Wortlaut durch Bezugnahme zum Inhalt der Beschreibung gemacht wird, der folgenden Beschreibung einer bevorzugten Ausführungsform der Erfindung sowie anhand der Zeichnung. Hierbei zeigen:
- Fig. 1: einen Längsschnitt durch eine Einrichtung nach der Erfindung in zusammengesetztem Zustand;
- Fig. 2: einen Querschnitt durch die Anordnung der Fig. 1;
- Fig. 3: einen Längsschnitt durch eine Gehäusehalbschale in aufgeklapptem Zustand;
- Fig. 4: eine der Fig. 1 entsprechende Seitenansicht der Vorrichtung;
- Fig. 5: eine Aufsicht auf eine zweite Ausführungsform bei noch nicht eingesetzten Elementen;
- Fig. 6: einen der Fig. 3 entsprechenden Schnitt bei der Ausführungsform nach Fig. 5;
- Fig. 7: einen Querschnitt durch die Anordnung der Fig. 5 längs Linie VII-VII in Fig. 5;
- Fig. 8: eine Stirnansicht einer weiteren Ausführungsform;
- Fig. 9: einen Teilschnitt durch eine Halbschale bei einer weiteren Ausführungsform;
- Fig. 10: eine Aufsicht auf eine geänderte Halbschale;
- Fig. 11: eine Aufsicht auf einen Steg für die in Fig. 10 dargestellte Halbschale;
- Fig. 12: eine der Fig. 10 entsprechende Aufsicht auf eine Halbschale bei einer weiteren Ausführungsform.
- Fig. 13: eine der Figur 2 entsprechende vereinfachte Darstellung bei einer weiteren Ausführungsform;
- Fig. 14: einen vergrößerten Teilschnitt durch eine Verriegelungseinrichtung zwischen beiden Gehäusehälften.

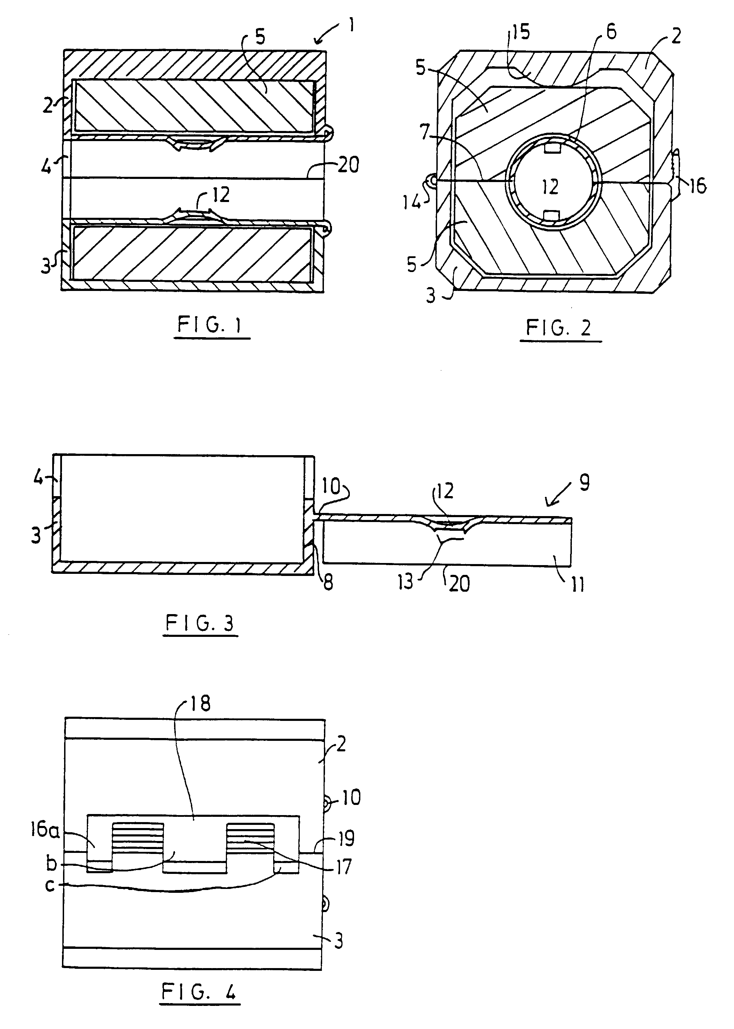

Fig. 1 zeigt die von der Erfindung vorgeschlagene Vorrichtung in betriebsfertigem Zustand, wobei man sich das elektrische Kabel, in dem das elektrische Rauschen unterdrückt werden soll, noch vorstellen muß. Die Vorrichtung enthält ein Gehäuse 1, das aus zwei Gehäusehalbschalen 2, 3 aufgebaut ist. Die beiden Gehäusehalbschalen 2, 3 sind so zusammengefügt, daß ihre offenen Seiten aufeinanderliegen. Dadurch weist das zusammengesetzte Gehäuse in seinen beiden Stirnflächen eine durchgehende Öffnung 4 auf, die miteinander fluchten.

In der einen Gehäusehalbschale 2 ist ein Element 5 aus einem ferromagnetischen Material eingesetzt, das etwa die gleiche Länge aufweist wie das Innere er Gehäusehalbschale 2. Das Element 5 aus ferromagnetischem Material, im folgenden als Ferritelement bezeichnet, weist auf seiner einen Seite eine halbzylindrische Nut 6 auf, die sich über die Länge des Ferritelementes 5 erstreckt. In dem zusammengesetzten Zustand, siehe Fig. 1 und Fig. 2, liegen die beiden Ferritelemente 5 einander so gegenüber, daß die beiden halbzylindrischen Nuten 6 sich zu einem zylindrischen Durchgang ergänzen. Die beiden aneinander angrenzenden Trennflächen 7 liegen dabei aufeinander. Dadurch wird ein geschlossener Ferritkörper um den Durchgang herum gebildet, durch den das elektrische Kabel hindurchführt.

An beiden Halbschalen 2, 3, siehe jetzt Fig. 3, ist an der Stirnseite 8 ein Steg 9 mit Hilfe eines Filmscharniers 10 angeformt. Der Steg 9 weist die Form eines halben Kreiszylinders oder anders ausgedrückt eines halben Rohres 11 auf. Etwa in der Mitte der Längserstreckung ist in dem Steg 9 ein federnder Vorsprung 12 angeformt, der in die durch das Halbrohr 11 gebildete Rinne vorspringt. Er weist zwei einzelne kleine Zacken 13 auf.

Die zweite Gehäusehalbschale 2, die in der Fig. 3 hinter der sichtbaren Gehäusehalbschale 3 zu denken ist, ist ebenfalls mit Hilfe eines Filmscharniers 14 an der Gehäusehalbschale 3 angelenkt, wobei auch diese zweite Gehäusehalbschale 2 in gleicher Weise einen über ein Filmscharnier 10 angelenkten Steg 9 aufweist.

In die beiden offenen Halbschalen 2, 3 in der in Fig. 3 dargestellten Position werden nun die Ferritelemente 5 eingelegt, und zwar in jeder Halbschale ein Ferritelement 5, wobei die Nuten 6 nach oben zu liegen kommen, d.h. zur offenen Seite der Halbschalen 2, 3. Der Boden einer der beiden Halbschalen 2 enthält dabei einen in Längsrichtung des Gehäuses verlaufenden abgerundeten Vorsprung 15, siehe oben in Fig. 2, auf dem das entsprechende Ferritelement 5 aufliegt. Es kann durch ein gewisses Abrollen auf der Kuppe des Vorsprungs 15 noch etwas kippen. Anschließend werden die beiden Verriegelungsstege 9 umgeklappt, bis sie in den Nuten 6 der Ferritelemente 5 liegen und einrasten. Dann wird das Gehäuse durch Zusammenklappen der beiden Halbschalen um das Filmscharnier 14 geschlossen. Auf der dem Filmscharnier 14 gegenüberliegenden Längsseite des Gehäuses weist die eine Halbschale 3 eine Lasche 16 auf, die an ihrer Innenseite einen einzelnen Zahn oder eine Zahnreihe aufweist. Die Lasche 16 ist dabei so dimensioniert, daß ihre Innenseite etwa bündig zu der Außenseite der gegenüberliegenden Halbschale verläuft. Diese zweite Halbschale, in Fig. 2 die obere Halbschale, enthält an dieser Stelle eine Zahnreihe 17, siehe auch Fig. 4. Die Zähne sind sägezahnartig geformt, so daß das Lösen der Lasche 16 ohne Werkzeug unmöglich gemacht wird. Beim Zusammenklappen der Gehäusehalbschalen 2, 3 werden diese so weit aufeinander zu gedrückt, bis die beiden Ferritelemente 5 an ihren Trennflächen 7 aneinander anliegen. In dieser Position bleibt die Lasche 16 dann gegenüber der Verzahnung 17 verriegelt. Die Lasche 16 weist drei Stege 16a, b, und c auf, mit denen sie an der Gehäusehalbschale 3 angeformt ist. Ihr freies Ende ist dann einstückig durch einen Querriegel 18 verbunden. Die Anformung der Lasche 16 befindet sich unmittelbar neben der Kante 19 der Gehäusehalbschale 3, die der anderen Gehäusehalbschale 2 gegenüberliegt. Damit soll eine Nachgiebigkeit der Verriegelung verhindert werden.

Wird die von der Erfindung vorgeschlagene Einrichtung um ein elektrisches Kabel herum zusammengeklappt, so gelangen die Vorsprünge 12 zur Anlage an der Außenseite des Kabels, so daß die Einrichtung insgesamt am Kabel kraftschlüssig festgelegt wird.

Bei verriegeltem Gehäuse liegen die Längskanten 20 der Trennebene der Stege 9 flächig aneinander an.

Bei der dargestellten Ausführungsform sind die beiden Halbschalen mit Hilfe eines Filmscharniers 14 aneinander angelenkt. Es wäre auch möglich, beide Gehäusehalbschalen als getrennte Teile auszubilden, und dann beispielsweise die Festlegung so zu gestalten, daß die Gehäusehalbschale 3 auf beiden Längsseiten je eine Lasche 16 und die andere Gehäusehalbschale auf beiden Seiten eine entsprechende Verzahnung 17 aufweist. Auch dies würde zu einer Verriegelung des Gehäuses in geschlossenem Zustand führen.

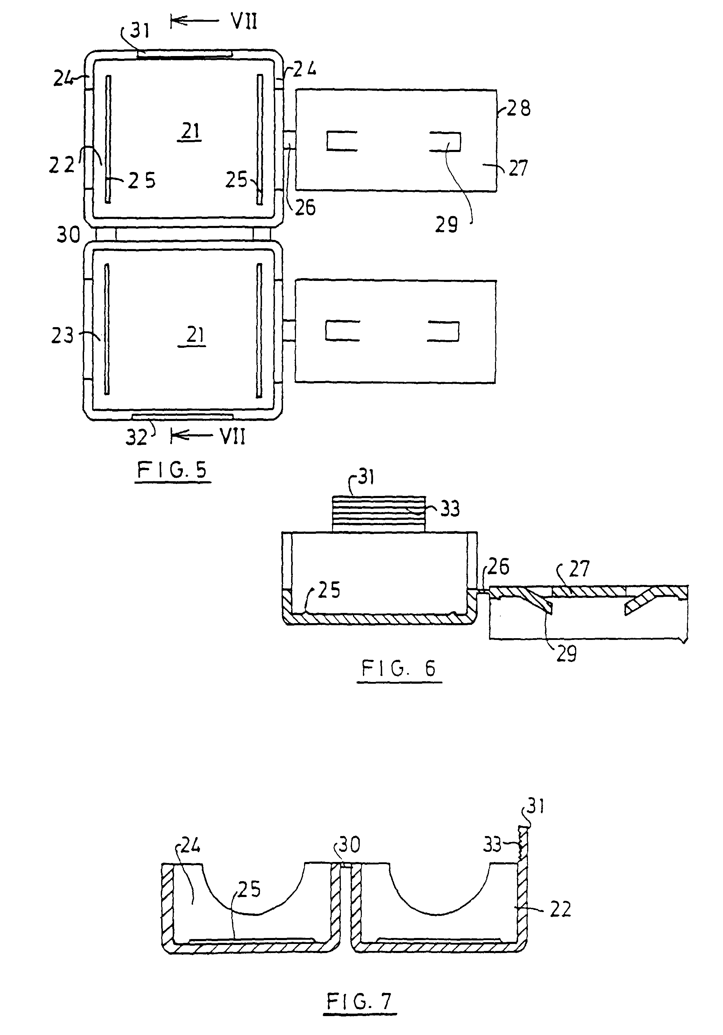

Die in den Fig. 5 bis 7 dargestellte Ausführungsform weicht von der vorherigen Ausführungsform etwas ab. Es werden daher nur die Unterschiede erläutert.

Auf dem Boden 21 beider Gehäusehalbschalen 22, 23 sind mit kurzem Abstand hinter den Stirnwänden 24 je zwei quer verlaufende Stege 25 angeformt. Die beiden Paare von Stegen 25 dienen zum Ausgleich von Toleranzen bei der Herstellung der in die Gehäusehalbschalen einzusetzenden Elemente. Sie ersetzen bei dieser Ausführungsform den Zentrierungsvorsprung 15, der bei der Ausführungsform nach Fig. 1 bis 4 auf dem Boden einer oder auch beider Halbschalen angeordnet ist.

Wiederum sind an den einseitigen Stirnwänden 24 der beiden Halbschalen 22, 23 über ein Filmscharnier 26 je eine im Querschnitt etwa U-förmige Rinne 27 angeformt. Diese Rinne wird zum Festlegen der Elemente verwendet und zu diesem Zweck um das Filmscharnier 26 umgeklappt, wobei die dem Filmscharnier 26 gegenüberliegende Stirnkante 28 in dem Gehäuse verriegelt wird. Einzelheiten sind nicht dargestellt.

Der Boden der Rinne 27 weist zwei Ausformungen 29 auf, die in das Innere der Rinne 27 vorspringen und dort zum Festhalten des elektrischen Kabels dienen.

An der den die beiden Gehäusehalbschalen 22, 23 verbindenden Filmscharnieren 30 abgewandten Längsseite weist eine der beiden Gehäusehalbschalen 22 eine Lasche 31 auf, die an ihrer Innenseite eine Verzahnung oder Verrippung aufweist.

Dementsprechend enthält die gegenüberliegende Seitenwand der anderen Gehäusehalbschale 23 ebenfalls eine Verrippung 32 in Sägezahnform, die mit der Verrippung an der Innenseite der Lasche 31 zusammenwirken soll.

Die Verzahnung 33 an der Innenseite der Lasche 31 ergibt sich insbesondere aus Fig. 6, die die Lasche 31 in Seitenansicht zeigt.

Auch aus Fig. 7 ist die Verzahnung 33 zu sehen.

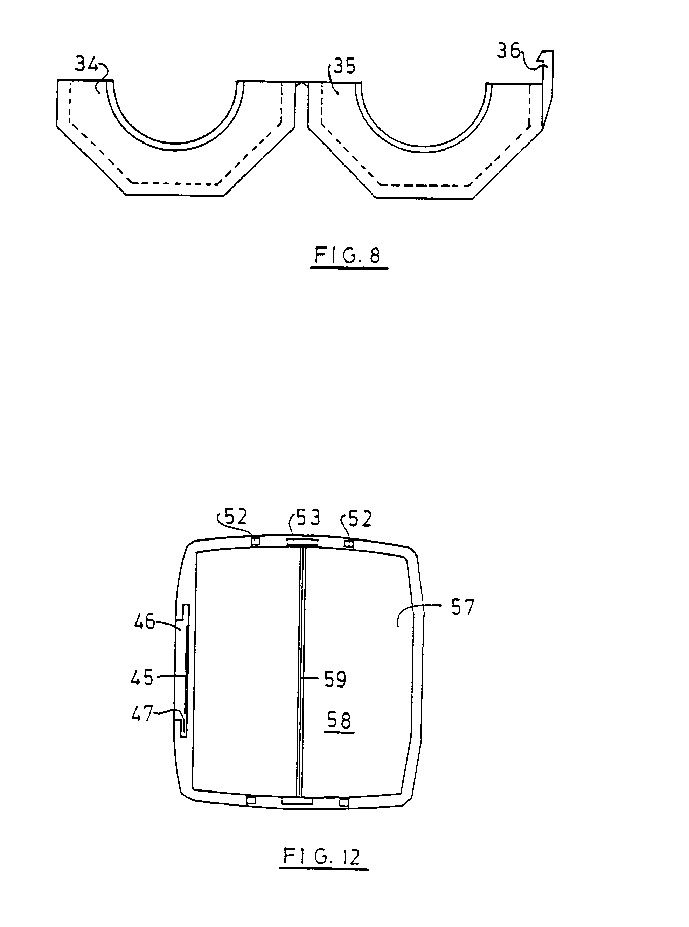

Fig. 8 zeigt eine nochmals weitere Ausführungsform, die ein aus zwei Gehäusehalbschalen 34, 35 bestehendes Gehäuse aufweist. Das aus den beiden Halbschalen 34, 35 bestehende Gehäuse wird um die in einer Halterung eingesetzten Elemente aus dem das Rauschen absorbierenden Material herum gespritzt. Durch den bei dieser Art der Herstellung auftretenden Schwund zieht sich das Gehäuse etwas zusammen, so daß es kraftschlüssig an der Außenseite der Elemente 5 haftet. Die bei der Herstellung der Elemente aus Ferrit-Material möglicherweise auftretenden Toleranzen werden bei dieser Art der Herstellung der Gehäusehalbschalen ausgeglichen, so daß ein einfacher Schnappverschluß 36 zur Befestigung ausreicht. Auch bei der Ausführungsform nach Fig. 8 kann die Innenseite der halbzylindrischen Nuten 6 der Elemente 5 von einer Schicht des Kunststoffs abgedeckt sein, der bei der Umspritzung mit hergestellt wird. Erforderlich ist dies jedoch nicht.

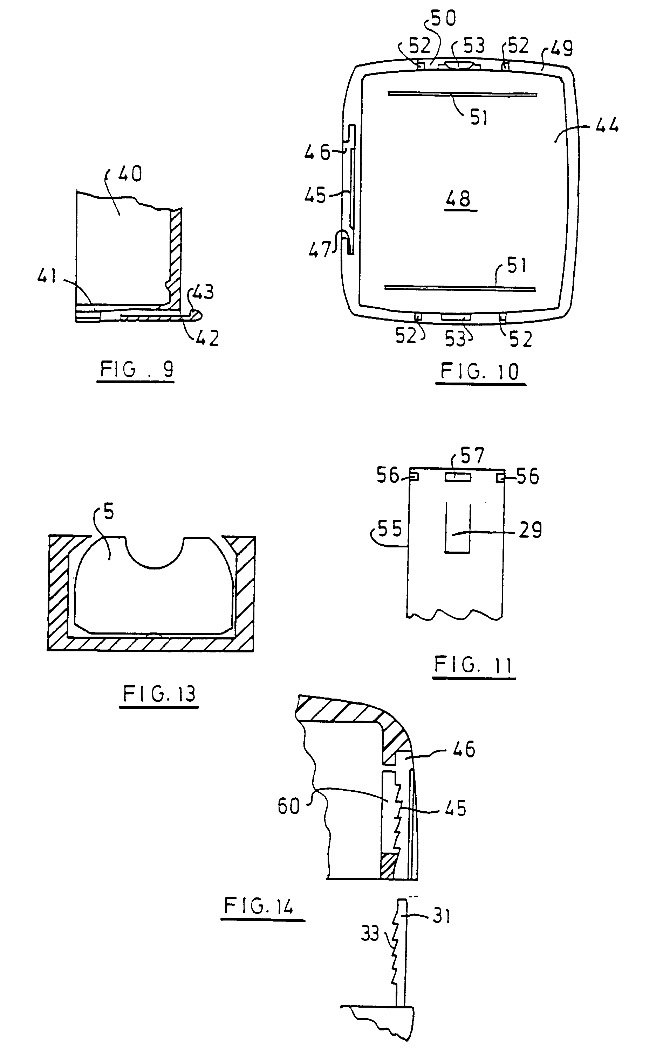

Bei der in Fig. 9 dargestellten Halbschale für das Unterbringen eines Elements aus einem das elektrische Rauschen verhindernden oder absorbierenden Material ist an einer Seitenwand 41 ein etwas federnder Haken 42 angeformt, der im Bereich seines freien Endes einen Widerhaken 43 bildet. Mit diesem Haken 42 läßt sich das Gehäuse 40 beispielsweise an einer Leiterplatte oder einem anderen Bauteil dadurch festlegen, daß der Haken 42 durch eine Öffnung oder einen Durchbruch hindurchgesteckt wird. An der gegenüberliegenden in Fig. 9 nicht dargestellten Seitenwand ist ein entsprechend geformter symmetrisch angeordneter Haken 42 vorhanden, so daß eine Festlegung durch einfaches Einschnappen erfolgen kann. Der Abstand zwischen der Unterseite des Bodens der Halbschale 40 und dem Widerhaken 43 kann auf die übliche Dicke von Leiterplatten abgestimmt werden.

Fig. 10 und 11 zeigen Einzelheiten einer weiteren Ausführungsform, bei der die zur Verriegelung der beiden Halbschalen 44 vorgesehene Rastverzahnung 45 innerhalb einer Ausnehmung 46 der Längsseitenwand der einen Halbschale 44 angeordnet ist. Die an der anderen Halbschale angeordnete Lasche ist dabei dann so geformt, daß sie in die Ausnehmung 46 eingreifen kann. Dabei gleiten die Ränder dieser Lasche in die seitlich ausgebildeten Nuten 47 der Ausnehmung 46. Dadurch ist nicht nur eine sichere Führung der Lasche beim Schließen des Gehäuses gewährleistet, sondern es wird auch ein Hintergreifen der Lasche im geschlossenen Zustand des Gehäuses verhindert.

In den Stirnwänden 49 der Halbschale 44 sind wiederum halbkreisförmige Öffnungen 50 zum Durchführen des Kabels, an dem die Halbschalen befestigt werden sollen, ausgebildet.

Der Boden 48 der Halbschale weist zwei quer zur Verbindungslinie der Öffnungen 50 verlaufende Rippen 51 auf, die zum Ausgleich von Toleranzen der Ferritkerne dienen sollen.

In den halbkreisförmigen Öffnungen 50 der Stirnwände 49 sind mehrere Vorsprünge 52, 53 angeordnet. Der mittlere Vorsprung 53 kann dabei eine Art Lasche aufweisen.

Mit den Vorsprüngen 52, 53 wirkt das jeweilige stirnseitige Ende des Querstegs 9 nach Fig. 11 zusammen. Fig. 11 zeigt einen solchen Quersteg 9, der ähnlich aufgebaut ist wie der Steg 9 der Ausführungsform nach Fig. 3, d. h. in Form einer Rinne bzw. eines halben Rohrs. Er weist im Bereich seiner stirnseitigen Enden einen Durchbruch 54 auf, der in Form und Abmessung dem laschenartigen Vorsprung 53 in den halbkreisförmigen Öffnungen 50 der Halbschale 44 entspricht.

An beiden Längsrändern 55 des Bauteils sind Kerben 56 eingeformt, die mit den Vorsprüngen 52 zur Verriegelung zusammenwirken. Die Kerben 56 brauchen nicht bis zur ebenen Trennlinie des rinnenartigen Bauteils durchzugehen.

Nach Einlegen eines Ferritelements in die Halbschale 44 wird der in Fig. 11 dargestellte Steg 9 in die halbkreisförmigen Öffnungen 50 eingeschoben und dort mit Hilfe des Zusammenwirkens der Vorsprünge 52, 53 und der Durchbrüche 54 bzw. Kerben 56 geführt und festgelegt.

Fig. 12 zeigt eine nochmals weitere Halbschale 57, die der Halbschale 44 der Ausführungsform nach Fig. 10 und 11 entspricht, bei der jedoch der Boden 58 der Halbschale eine in Längsrichtung verlaufende Rippe 59 aufweist, die an die Stelle der beiden Rippen 51 tritt. Die Rippe 59 weist eine Querschnittsform auf, die etwa der Querschnittsform der Rippe 25 in Fig. 6 entspricht. Die Querschnittsform ist also etwa dreieckig, gegebenenfalls mit einer abgerundeten Oberkante.

Bei allen dargestellten Ausführungsformen werden die beiden Halbschalen mit den eingelegten Kernen aus dem das Rauschen absorbierenden Material um die Leitung herumgeklappt und geschlossen. Dabei greift die Lasche mehr oder weniger weit in die Verzahnung des anderen Teils ein, abhängig von der tatsächlichen Größe der eingelegten Elemente. Diese können toleranzbedingt etwas unterschiedliche Abmessungen haben. In diesem Fall könnte also das Gehäuse gegenüber der Darstellung der Figuren 1, 2 und 4 noch leicht geöffnet sein, wobei aber in jedem Fall sichergestellt ist, daß die Trennflächen 7 der beiden Elemente dicht aneinander anliegen.

Bei der in Fig. 13 vereinfacht dargestellten Ausführungsform sind die beiden Längsseiten des Ferritkerns 5, d.h. beidseits der halben Zylinderinnenöffnung, leicht bauchig ausgebildet, insbesondere an der Seite, an der das Gehäuse offen ist. Das Gehäuse weist an dieser offenen Seite einen Hinterschnitt auf. Auf diese Weise kann der Ferritkern 5 leichter in dem Gehäuse gehaltert werden, was insbesondere bei der Lagerung und der Handhabung des Absorbers vor dem Zusammensetzen von Interesse ist.

Fig. 14 zeigt in einem vergrößerten Teilschnitt eine Verriegelungseinrichtung, die ähnlich aufgebaut ist wie die Verriegelungseinrichtung der Ausführungsform nach Fig. 11 und 12. Die Rastverzahnung 45, die in der Ausnehmung 46 angeordnet ist, ist in diesem Beispiel an der Außenseite einer leicht federnden Lasche 6 angeordnet. Wird nun der Steg 31 mit der Verzahnung 33 in die Ausnehmung 46 eingeschoben, so federt die Lasche 60 etwas zurück und verkrallt sich anschließend besonders fest mit dem Steg 31.

Zum Öffnen kann man mit einem Schraubenzieher oder einem sonstigen Werkzeug auf die Außenseite des Stegs 31 drücken und dadurch die Lasche 60 etwas nach Innen verformen.

## Patentansprüche

1. Einrichtung zum Absorbieren des elektrischen Rauschens, mit
1.1 einem Gehäuse (1), das
1.1.1 zwei Gehäusehalbschalen (2, 3) zur Aufnahme je eines Elementes (5) aus ein Rauschen verhinderndem Material und
1.1.2 in zusammengesetztem Zustand in seinen beiden Stirnseiten je eine Durchgangsöffnung (4) für ein elektrisches Kabel aufweist,
1.2 zwei Elementen (5) aus dem erwähnten Material, die
1.2.1 in den Gehäusehalbschalen (2, 3) angeordnet sind und
1.2.2 jeweils eine halbzylindrische Nut (6) aufweisen, die
1.2.3 in zusammengesetztem Zustand des Gehäuses (1) einen geschlossenen zylindrischen Durchgang für das elektrische Kabel bilden, sowie mit
1.3 einer Festlegeinrichtung zum Festlegen der Elemente (5) aus dem erwähnten Material in der jeweiligen Halbschale (2, 3), dadurch gekennzeichnet, daß zur Verriegelung des Gehäuses in geschlossenem Zustand mindestens an der einen Halbschale eine mit einer Verzahnung versehene Lasche (16) vorgesehen, insbesondere angeformt ist, die mit einer Verzahnung (17) an der jeweils anderen Gehäusehalbschale (2) zusammenwirkt.

2. Einrichtung nach Anspruch 1, bei der die Festlegeinrichtung für jede Halbschale (2, 3) einen Steg (9) aufweist, der sich von Stirnseite zu Stirnseite des Gehäuses (1) erstreckt und durch die halbzylindrischen Nuten (6) beider Elemente aus dem Material verläuft.

3. Einrichtung nach einem der vorhergehenden Ansprüche, bei der beide Gehäusehalbschalen (2, 3) durch ein Filmscharnier (14) an ihrer einen Längsseite miteinander verbunden sind.

4. Einrichtung nach einem der vorhergehenden Ansprüche, bei der zur Ausrichtung eines Elementes (5) aus dem Material an dem Boden der einen Gehäusehalbschale (2) ein abgerundeter starrer Vorsprung (15) angeformt ist, der sich vorzugsweise über die gesamte Länge des Gehäuses (1) erstreckt.

5. Einrichtung nach einem der vorhergehenden Ansprüche, bei der der Steg (9) die Form eines Halbzylinders (11) aufweist.

6. Einrichtung nach einem der vorhergehenden Ansprüche, bei der der Steg (9) vorzugsweise in der Mitte seiner Längserstreckung einen nach innen gerichteten Vorsprung (12) zum Festlegen des Gehäuses (1) an dem elektrischen Kabel aufweist.

7. Einrichtung nach einem der vorhergehenden Ansprüche, bei der der Steg (9) mit Hilfe eines Filmscharniers (10) mit einer Stirnseite (8) einer Gehäusehalbschale (2, 3) verbunden ist.

8. Einrichtung nach einem der Ansprüche 1 bis 6, bei der der Steg (9) insbesondere seitlich in die Gehäusehalbschale (2, 3) einschiebbar ist.

9. Einrichtung nach einem der vorhergehenden Ansprüche, bei der die beiden Gehäusehalbschalen (34, 35) um die Elemente (5) aus dem ein Rauschen absorbierenden Material herum gespritzt sind.

10. Einrichtung nach einem der vorhergehenden Ansprüche, bei dem die Festlegung der Elemente (5) in den Gehäusehalbschalen (34, 35) durch ein kraftschlüssiges Anliegen der Gehäusehalbschalen (34, 35) an den Elementen (5) erfolgt, das insbesondere durch eine Schrumpfung des Gehäusematerials bewirkt wird.

## Claims

1. Device for absorbing electrical noise having
1.1 a casing (1), which
1.1.1 has two casing half-shells (2, 3) for receiving in each case one noise preventing material element (5) and
1.1.2 in the assembled state in its two end faces in each case one passage opening (4) for an electrical cable,
1.2 two elements (5) from said material, which
1.2.1 are placed in the casing half-shells (2, 3) and
1.2.2 in each case have a semicylindrical groove (6), which
1.2.3 in the assembled state of the casing (1) form a closed, cylindrical passage for the electrical cable, as well as with
1.3 a fixing device for fixing the elements (5) made from said material in the particular half-shell (2, 3), characterized in that for locking the casing in the closed state at least on one half-shell is provided, in particular shaped, a tongue (16) having a tooth system, which cooperates with a tooth system (17) on the in each case other casing half-shell (2).

2. Device according to claim 1, wherein the fixing device for each half-shell (2, 3) has a web (9) extending from one end face to the other of the casing (1) and passing through the semicylindrical grooves (6) of the two elements made from the material.

3. Device according to one of the preceding claims, wherein the two casing half-shells (2, 3) are interconnected on one longitudinal side thereof by a film hinge (14).

4. Device according to one of the preceding claims, wherein for the alignment of an element (5) made from the material on the base of one casing half-shell (2) is shaped a rounded, rigid projection (15), which preferably extends over the entire length of the casing (1).

5. Device according to one of the preceding claims, wherein the web (9) is in the form of a semicylinder (11).

6. Device according to one of the preceding claims, wherein the web (9), preferably in the centre of its longitudinal extension, has an inwardly directed projection (12) for fixing the casing (1) to the electrical cable.

7. Device according to one of the preceding claims, wherein the web (9) is connected with the aid of a film hinge (10) to one end face (8) of a casing half-shell (2, 3).

8. Device according to one of the claims 1 to 6, wherein the web (9) is in particular laterally insertable into the casing half-shell (2, 3).

9. Device according to one of the preceding claims, wherein the two casing half-shells (34, 35) are injection moulded around the noise absorbing material elements (5).

10. Device according to one of the preceding claims, wherein the fixing of the elements (5) in the casing half-shells (34, 35) takes place by a non-positive engagement of the casing half-shells (34, 35) on the elements (5), which is in particular brought about by a shrinkage of the casing material.

## Revendications

1. Dispositif pour l'absorption du bruit électrique comprenant
1.1 un coffret (1) qui
1.1.1 présente deux demi coquilles de coffret (2, 3) pour le logement respectif d'un élément (5) en matériau anti-bruit et,
1.1.2 à l'état monté dans ses deux faces avant, une ouverture de passage (4) pour un câble électrique,
1.2. deux éléments (5) réalisées dans ledit matériau, qui
1.2.1 sont disposés dans les demi coquilles de boîtier (2, 3) et
1.2.2 qui présentent respectivement une rainure semi-cylindrique (10), qui
1.2.3 à l'état monté du coffret (1) forment un passage cylindrique fermé pour le câble électrique, comprenant également
1.3 un dispositif de fixation pour la fixation des éléments (5) dans ledit matériau dans la demi coquille respective (2, 3), caractérisée en ce que pour le verrouillage du coffret à l'état fermé au moins sur l'une des demi coquilles, il est prévu une languette (16) munie d'une denture, en particulier moulée qui coopère avec une denture (17) se trouvant sur l'autre demi coquille de coffret (2).

2. Dispositif selon la revendication 1, où le dispositif de fixation pour chaque semi-coquille (2, 3) présente un listel (9) qui s'étend de la face avant à la face arrière du coffret (1) et passe par les rainures semi-cylindriques (6) des deux éléments réalisés dans ledit matériau.

3. Dispositif selon l'une des revendications précédentes, où les deux coquilles semi-cylindriques de boîtier (2, 3) sont reliées par une charnière à feuille (14) sur l'une de leur face longitudinale.

4. Dispositif selon l'une des revendications précédentes, où pour l'orientation d'un élément (5) réalisé dans ce matériau au fond de l'une des demi coquilles (2) est moulée une saillie rigide arrondie (15) qui s'étend de préférence sur toute la longueur du coffret (1).

5. Dispositif selon l'une des revendications précédentes, où le listel (9) présente la forme d'un demi cylindre (11).

6. Dispositif selon l'une des revendications précédentes, où le listel (9) présente de préférence au milieu de son extension longitudinale une saillie dirigée vers l'intérieur (12) pour la fixation du coffret (1) au câble électrique.

7. Dispositif selon l'une des revendications précédentes, où le listel (9) est relié à une face avant (8) d'une demi coquille de coffret (2, 3) à l'aide d'une charnière à feuille (10).

8. Dispositif selon l'une des revendications 1 à 6, où le listel (9) est insérable en particulier latéralement dans la demi coquille de coffret (2, 3).

9. Dispositif selon l'une des revendications précédentes, où les deux demi coquilles de coffret (34, 35) sont moulées par injection autour des éléments (5) réalisés dans un matériau anti-bruit.

10. Dispositif selon l'une des revendications précédentes, où la fixation des éléments (5) dans les demi coquilles de coffret (34, 35) s'effectue par adhérence mécanique des demi coquilles de coffret (34, 35) contre les éléments (5), cette adhérence provoquant en particulier une rétraction du matériau de coffret.
